# DEMANDE DE BREVET EUROPEEN

(11) **EP 4 676 189 A1**
(43) Date de publication de la demande: **07.01.2026**
(21) Numéro de dépôt: 24186961.9
(22) Date de dépôt: 05.07.2024
(51) Int. Cl.: H10F 19/80, H10F 19/85

(54) **PANNEAU PHOTOVOLTAÏQUE LÉGER, ET PROCÉDÉ DE FABRICATION D'UN TEL PANNEAU**

(71) Demandeur: LightSeeds SA, 2065 Savagnier (CH)
(72) Inventeur: DUVOISIN, Pierrick, 2065 Savagnier (CH); PERRET, Laure-Emmanuelle, 2000 Neuchâtel (CH); LI, Heng-Yu, 2022 Bevaix (CH)
(74) Mandataire: P&TS SA (AG, Ltd.)

(57) **Abrégé**

Procédé de fabrication de panneau photovoltaïque, comprenant les étapes suivantes :
placer un premier volume d'un matériau d'encapsulation sur le fond d'un moule ;
placer un substrat en matériau biosourcé par-dessus ledit premier volume, l'épaisseur dudit matériau biosourcé étant comprise entre 2mm et 50mm ;
disposer une ou plusieurs cellules photovoltaïques sur la face supérieure du substrat ;
placer un deuxième volume d'un matériau d'encapsulation par-dessus les cellules photovoltaïques et la face supérieure du substrat ;
placer un troisième volume d'un matériau d'encapsulation à l'intérieur du moule tout autour du substrat ;
refermer le moule;
chauffer lesdits matériaux d'encapsulation de manière à fusionner les trois volumes de manière à former une enveloppe hermétique autour du substrat et des cellules;
refroidir les lesdits matériaux d'encapsulation ;
extraire du moule le panneau photovoltaïque encapsulé sur toutes ses faces.

## Description

### Domaine technique

La présente invention concerne un panneau photovoltaïque léger, et un procédé de fabrication d'un tel panneau photovoltaïque.

### Etat de la technique

Les panneaux photovoltaïques comportent généralement des cellules photovoltaïques en matériau semiconducteur prises en sandwich entre deux feuilles d'encapsulant. Un verre et/ou une feuille polymérique sont généralement disposés à l'avant et l'arrière des cellules pour apporter une stabilité mécanique au module ainsi que pour garantir la protection des cellules solaires et les protéger de l'humidité et de la poussière. Le verre ou la feuille polymérique placée à l'avant des cellules est généralement recouverte d'une couche antireflet pour réduire la réflexion de la lumière solaire.

Le substrat, ou couche arrière, offre un support structurel pour le panneau dans son ensemble. Les matériaux de substrat les plus utilisés dans les panneaux photovoltaïques comprennent le verre, les matériaux polymères, etc. Un cadre en aluminium est souvent prévu pour renforcer la stabilité mécanique du panneau et faciliter son installation.

Bien que très usuelle, cette construction présente plusieurs inconvénients. En premier lieu, le panneau ainsi réalisé est relativement lourd. La couche de verre par-dessus le panneau est fragile, et peut se briser en formant des éclats dangereux. Il en va de même du substrat si celui-ci est réalisé en verre. Enfin, l'énergie grise pour fabriquer un tel panneau et pour le transporter est importante.

### Bref résumé de l'invention

Un but de la présente invention est de proposer un panneau photovoltaïque, et un procédé de fabrication d'un tel panneau photovoltaïque, qui réduise ces inconvénients, ou en tout cas qui offre un meilleur compromis entre les différentes contraintes auquel un panneau photovoltaïque doit faire face.

Selon l'invention, ces buts sont atteints notamment au moyen d'un procédé de fabrication de panneau photovoltaïque, comprenant les étapes suivantes :
placer un premier volume d'un matériau d'encapsulation sur le fond d'un moule ;
placer un substrat en matériau biosourcé par-dessus ledit premier volume, l'épaisseur dudit matériau biosourcé étant comprise entre 2mm et 50mm ;
disposer une ou plusieurs cellules photovoltaïques sur la face supérieure du substrat ;
placer un deuxième volume d'un matériau d'encapsulation par-dessus les cellules photovoltaïques et la face supérieure du substrat ;
placer un troisième volume d'un matériau d'encapsulation à l'intérieur du moule autour du substrat ;
refermer le moule ;
chauffer lesdits matériaux d'encapsulation de manière à fusionner les trois volumes de manière à former une enveloppe hermétique autour du substrat et des cellules;
refroidir lesdits matériaux d'encapsulation ;
extraire du moule le panneau photovoltaïque encapsulé sur toutes ses faces.

Avantageusement, afin d'obtenir une encapsulation monolithique et très résistante grâce à une fusion efficace des différents volumes d'encapsulation, le premier, deuxième et troisième volumes d'encapsulation peuvent être constitués d'un même matériau, ou au moins de matériaux similaires pouvant bien se mélanger lors de l'étape de fusion.

Par exemple, les matériaux des trois volumes pourraient comprendre des polyoléfines avec certaines variations de composition. Par exemple, le deuxième volume pourrait comprendre une polyoléfine équivalente à celle du premier et troisième volume, contenant en outre des pigments ou des particules servant à moduler les propriétés optiques dudit deuxième volume, qui fait office d'encapsulant frontal du panneau photovoltaïque (frontsheet).

Selon un mode de réalisation avantageux, les cellules peuvent être collés sur le substrat, par exemple, au moyen d'une double bande adhésive.

Alternativement, une quatrième couche d'un matériau d'encapsulation peut être prévue entre la face supérieure du substrat en matériau biosourcé et les cellules photovoltaïques. Cette quatrième couche peut servir à fixer les cellules sur le substrat. En fusionnant avec le deuxième et/ou le troisième volume d'encapsulation, cette quatrième couche peut en plus contribuer à la rigidité et stabilité mécanique du panneau photovoltaïque.

Avantageusement, la quatrième couche de matériau d'encapsulation peut être constituée d'un même matériau, ou au moins d'un matériau similaire à celui du deuxième et/ou troisième volume d'encapsulation, pouvant bien se mélanger lors de l'étape de fusion.

Ces buts sont aussi atteints au moyen d'un panneau photovoltaïque comportant :
un substrat en matériau biosourcé avec une épaisseur comprise entre 2mm et 50mm ;
une ou plusieurs cellules photovoltaïques sur la face supérieure du substrat;
une encapsulation enveloppant ledit substrat et lesdites cellules photovoltaïques sur toutes les faces.

L'épaisseur du substrat en matériau biosourcé peut plus avantageusement être comprise en 10 mm et 50 mm. Cette épaisseur est plus importante que les substrats classiques en verre ou polymère, par contre, en termes de poids et d'empreinte environnemental le substrat en matériau biosourcé est avantageux. De plus, en combinaison avec l'encapsulation sur toutes les faces, ces épaisseurs de substrat en matériau biosourcé peuvent garantir la rigidité des panneaux ; même ceux d'une surface importante, par exemple 1 m² et plus, comme les panneaux solaires typiquement utilisés sur les constructions et infrastructures.

L'encapsulation peut comprendre une feuille avant (frontsheet) sur la face avant, formée à partir du deuxième volume.

Le matériau d'encapsulation utilisé pour le deuxième volume peut être traité, par exemple texturé ou coloré, différemment du matériau d'encapsulation utilisé pour le premier et pour le troisième volume. Cela permet de faciliter la certification de la feuille avant pour des applications où cette feuille doit être certifiée.

Le matériau d'encapsulation utilisé pour le deuxième volume peut être différent du matériau d'encapsulation utilisé pour le premier et pour le troisième volume. Cela permet également de faciliter la certification de la feuille avant pour des applications où cette feuille doit être certifiée, ou de donner d'autres propriétés à cette feuille avant soumise à des contraintes climatiques et environnementales importantes.

Le matériau du deuxième volume, et/ou son traitement, peuvent être choisi en fonction de sa transparence dans les bandes spectrales utiles pour les cellules, de la possibilité de le structurer, de réduire les reflets, ou de le colorer, et/ou de sa résistance aux agressions mécaniques, physiques ou chimiques par exemple.

Dans le contexte de cette demande, on désigne par matériau biosourcé des matériaux constitués pour au moins 80% en masse de matière organique d'origine microbienne, végétale, animale ou fongique. Les matériaux biosourcés incluent par exemple des matériaux à base de cellulose (bois, papier, carton), de textiles organiques, de plantes à base de fibres (comme le chanvre, le lin, etc), les micomatériaux, etc.

Dans un mode de réalisation préférentiel, le matériau biosourcé comporte au moins 95% en masse de matière organique, le reste pouvant inclure des vernis ou des traitements hydrophobes ou ignifuges par exemple.

Dans un mode de réalisation préférentiel, le matériau biosourcé est à base de fibres de cellulose, de préférence à base de papier ou de carton, de préférence à base de carton structuré, de préférence alvéolaire.

Le substrat peut par exemple comporter une âme en carton en nid d'abeille ou plissé avec deux feuilles en papier ou en carton sur le dessus et le dessous.

L'avantage d'un substrat en bois ou en carton est de d'offrir une rigidité relativement élevée malgré une densité faible, ce qui permet de réaliser des panneaux légers. D'autre part, l'impact environnemental de ce matériau est réduit, notamment l'énergie grise nécessaire à sa production. Enfin, le papier et le carton sont aisément recyclables au sein de filières de recyclage bien établies.

Le panneau photovoltaïque est de préférence dépourvu de couche en verre, ce qui permet de réduire son poids et son empreinte écologique, tout en réduisant le risque en cas de bris.

Lors de la fabrication, le premier volume et le deuxième volume du matériau d'encapsulation peuvent être apportés sous forme de feuilles.

Le quatrième volume peut être apporté sous forme de feuille.

Le troisième volume d'encapsulation peut être apporté sous forme de granulé, d'un cadre préfabriqué, ou d'une bande extrudée.

Les différents volumes d'encapsulation peuvent être fusionnés en un volume monolithique en les faisant fondre simultanément dans une enceinte chauffée.

Le deuxième volume d'encapsulation (frontsheet) peut être assemblé par lamination durant la même étape du processus.

Le premier, deuxième et quatrième volumes n'ont pratiquement pas de fonction structurelle mécanique ; on les réalisera de préférence avec une épaisseur réduite, par exemple entre 180 et 1000 microns. Cela permet de réduire le poids, l'empreinte écologique, ainsi que de maximiser la transparence. Ces volumes servent aussi de barrière contre l'humidité, l'oxygène et les UBVS, ainsi que d'isolation électrique.

Le troisième volume autour du substrat a de préférence une fonction structurelle mécanique, et permet de protéger contre l'humidité les bords relativement fragiles du substrat, tout en augmentant la rigidité de l'ensemble. On lui donnera donc de préférence une épaisseur comprise entre 2 et 20mm. A cet effet, l'interstice entre les parois latérales du substrat et le moule est de préférence comprise entre 2mm et 20mm, en sorte que le troisième volume forme un cadre rigide tout autour du substrat une fois refroidi.

Le matériau d'encapsulation et le matériau pour la feuille supérieure peuvent être une polyoléfine, par exemple du polyéthylène, du polypropylène, éthylène vinyl acetate (EVA), ionomère ou autre matériau thermoplastique et/ou composite. Le matériau est choisi pour apporter une grande stabilité aux cellules solaires contre les agressions climatiques extérieures. Par ailleurs, leur point de fusion est entre 130 et 200°C, donc nettement en-dessous de la température à laquelle le carton s'enflamme. Il est donc possible de le faire fondre autour de substrat, et de fusionner les différents volumes, sans détruire le substrat.

La feuille supérieure du panneau peut être avantageusement texturée, afin de diffuser la lumière, de réduire les pertes par réflexion, et d'offrir un effet anti-reflet.

Cette texturation peut être obtenue pendant le moulage, grâce à une texture de forme complémentaire à la texture désirée sur la face interne du moule.

Les cellules photovoltaïques peuvent être collées sur le substrat, de préférence au moyen de la feuille de matériau d'encapsulation (quatrième volume) disposée entre le substrat et les cellules photovoltaïques. Cette feuille peut être fusionnée avec les autres volumes du matériau d'encapsulation.

Le panneau photovoltaïque ainsi réalisé peut notamment être appliqué verticalement sur une paroi antibruit, une barrière, une glissière, une palissade, par exemple. Le poids léger de ce panneau le rend avantageux pour ces applications en position verticale où l'accrochage des panneaux conventionnels, plus lourds pose des difficultés.

Le panneau photovoltaïque ainsi réalisé peut aussi être appliqué sur toute structure fixe d'un bâtiment, par exemple contre une paroi, sur un toit, un couvert à voitures, etc.

Le panneau photovoltaïque ainsi réalisé peut être recyclé. Il est possible de décoller l'encapsulation, en la déchirant et en tirant dessus. Le substrat et les cellules peuvent alors être extraits et aisément séparés pour être recyclés séparément.

### Brève description des figures

Des exemples de mise en oeuvre de l'invention sont indiqués dans la description illustrée par les figures annexées dans lesquelles :
- La figure 1 illustre une vue en coupe d'un exemple de panneau photovoltaïque selon l'invention ;
- La figure 2 illustre une vue en perspective d'un exemple de moule qui peut être utilisé dans le procédé de fabrication de l'invention.

### Exemple(s) de mode de réalisation de l'invention

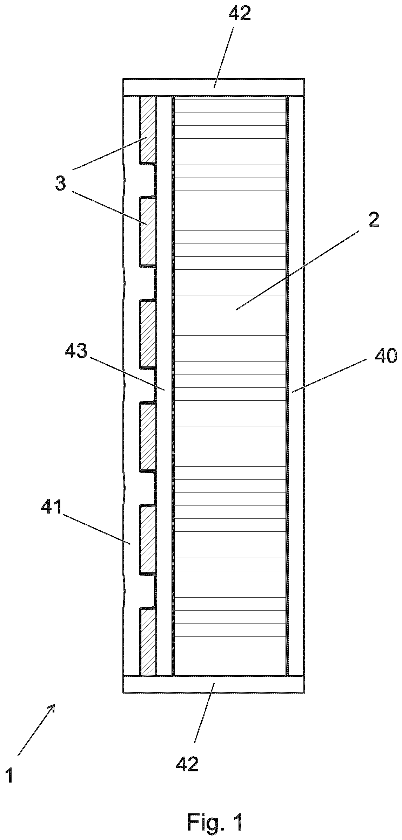

Un exemple de panneau photovoltaïque selon l'invention est illustré en coupe sur la figure 1. La face avant du panneau, destinée à recevoir la lumière, est sur la gauche de la figure ; la face arrière sur la droite. Il est construit autour d'un substrat en matériau biosourcé 2 qui lui donne sa rigidité. Le substrat 2 est avantageusement réalisé en carton, et comprend de préférence une structure alvéolaire, par exemple en nid d'abeille ou plissé, prise en sandwich entre deux feuilles de papier ou de carton. Cette structure lui donne une rigidité et une résistance à la compression élevée, tout en restant léger.

La superficie du substrat, et donc celle du panneau, peut être quelconque. L'invention est cependant particulièrement adaptée à des panneaux employés à l'extérieur, par exemple pour alimenter des ménages, des ateliers, une batterie ou pour être réinjectée dans le réseau électrique. Dans un mode de réalisation préférentiel, sa surface est donc comprise entre 0,5m² et 3m². Le panneau peut avoir la dimension usuelle des panneaux photovoltaïques (environ 1,7 mètre x 1 mètre). La puissance nominale du panneau photovoltaïque est de préférence comprise entre 100W et 1000W.

Le substrat peut être traité par exemple avec un vernis ou un autre produit ignifuge et/ou hydrophobe.

Au moins certaines faces du substrat peuvent être peintes ou colorées d'une autre manière. Une face avant peinte est utile par exemple dans une application sur une bordure de route, afin de limiter l'éblouissement des conducteurs. L'impression peut aussi être décorative ou publicitaire.

Des cellules photovoltaïques 3 sont montées sur la face avant du substrat 2. Les cellules ont par exemple une surface rectangulaire ou octogonales, avec des côtés principaux d'une largeur entre 5 et 20cm. Elles comportent une couche active photosensible formée d'un matériau semiconducteur, par exemple du silicium ou autre.

Le panneau comporte de préférence plusieurs cellules photovoltaïques 3 reliées électriquement entre elles.

L'ensemble est encapsulé et protégé de l'humidité, des ultraviolets et des poussières par une encapsulation monolithique qui couvre toutes ses faces. La face arrière est protégée par une feuille 40 formant un premier volume de matériau d'encapsulation qui adhère sur le dos du substrat 2. La face avant est protégée par une feuille 41 formant un deuxième volume de matériau d'encapsulation qui adhère directement sur les cellules photovoltaïques 3 et sur la face avant du substrat 2, ou sur la feuille intermédiaire 43 (quatrième volume) décrite plus loin. L'épaisseur de ces feuilles 40, 41, et 43 est de préférence comprise entre 180 et 1000 microns.

Les faces latérales du panneau photovoltaïque 1 sont protégées par un cadre 42 formant un troisième volume d'encapsulation et réalisé de préférence dans le même matériau que les feuilles 40, 41 et 43. Ce cadre a de préférence une épaisseur plus importante que celle des feuilles 40, 41 et 43, par exemple une épaisseur comprise entre 2 et 20mm. Il offre une protection mécanique et contre l'humidité et les poussières des faces latérales du substrat 2 et des cellules 3. Il permet en outre de rigidifier l'ensemble.

Les quatre volumes 40, 41, 42 et 43 sont fusionnés entre eux en sorte que l'encapsulation forme un ensemble monolithique tout autour du substrat 2. Le deuxième volume 41 (face avant) peut être fusionné ou en tout cas laminé au troisième volume 42, de manière à ce que les quatre volumens forment un ensemble monolithique tout autour du panneau photovoltaïque 1. Des trous de passage (non représentés) sont avantageusement prévus sur la face arrière ou sur la tranche du panneau, afin de faire passer des fils électriques permettant de raccorder les cellules à un onduleur, un autre panneau ou un consommateur.

Les cellules photovoltaïques 3 sont fixées sur le substrat 2, par exemple par collage, par exemple au moyen d'un adhésif double face. Dans le mode de réalisation décrit, elles sont fixées au substrat par une feuille de matériau d'encapsulation 43 qui adhère aussi bien au substrat 2 qu'à la face arrière des cellules 3 et de la feuille 41. Le matériau de la feuille 43 est de préférence le même que celui des volumes 40, 41, 42, Cette feuille est de préférence fusionnée avec le volume 42 sur sa tranche, et avec la feuille 41 sur une partie de sa face avant. L'épaisseur de cette feuille est de préférence comprise entre 180 et 1000 microns.

Le matériau d'encapsulation et celui de la face avant 41 sont choisis pour résister aux variations de température, à l'eau, à la vapeur d'eau, à l'oxygène et à l'exposition aux UV. Il peut être transparent afin de laisser passer la lumière vers les cellules 3. Un matériau coloré, qui laisse passer seulement une partie de la lumière incidente dans une bande spectrale donnée, peut cependant être utilisé.

La face avant de la feuille 41 peut être texturée afin par exemple de diffuser la lumière incidente et/ou d'éviter les réflexions qui réduisent le rendement tout en risquant d'éblouir les observateurs.

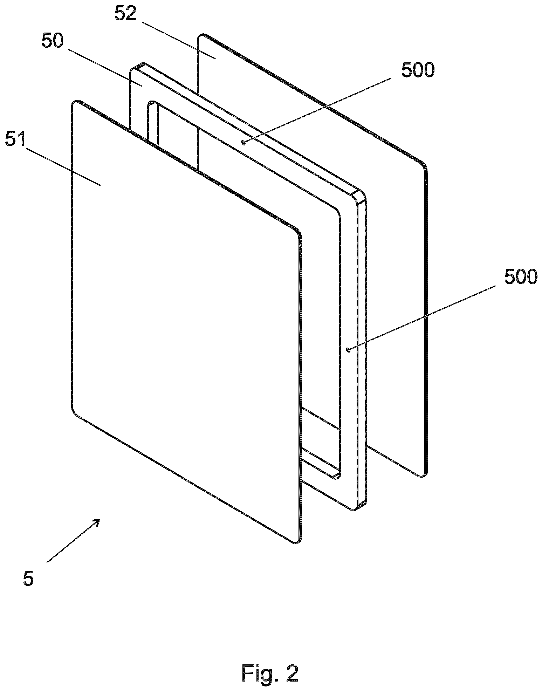

Le panneau photovoltaïque 1 décrit à titre d'exemple peut être fabriqué par laminage et moulage dans un moule 5 tel que celui illustré sur la figure 2. Le moule comporte un fond 52, un cadre 50 et un couvercle 51. Ces matériaux peuvent être réalisés en métal ; les faces internes peuvent être revêtues de Teflon^{®} pour faciliter le démoulage.

Les éléments 50, 51, 52 peuvent être alignés lors du moulage au moyen de trous 500 dans un des éléments, ici dans le cadre 50, qui collaborent avec des portions protubérantes dans un autre élément, par exemple sur le fond ou le couvercle. Les éléments d'alignement 500 peuvent être disposés de manière à garantir que les textures sur la face avant du panneau sont orientées correctement. Il est aussi possible d'intégrer le fond 52 et le cadre 50 en un seul ensemble non démontable.

Pour la fabrication, le cadre 50 est tout d'abord monté sur le fond 52. Une feuille de matériau d'encapsulation 40 est ensuite disposée sur le fond 52, de manière à recouvrir tout le fond à l'intérieur du cadre.

Le substrat 2 en matériau biosourcé, par exemple en carton, est ensuite empilé par-dessus la feuille 40. La feuille intermédiaire 43, ou d'autres moyens de fixation, sont disposés par-dessus ce substrat, puis les cellules photovoltaïques 3 sont placées sur cette feuille ou ces moyens de fixation. Les cellules photovoltaïques sont connectées électriquement entre elles avant ou après leur placement dans le moule. Les fils de connexion vers cet ensemble de cellules traversent de préférence le substrat 2 et la feuille arrière 40, à travers des trous préparés à l'avance (non représentés). Les trous dans la feuille arrière 40 se rebouchent autour des fils lors de la fusion de la feuille arrière, de manière à garantir l'étanchéité.

La feuille d'encapsulation avant 41 est finalement disposée par-dessus les cellules, et le troisième volume d'encapsulation 42 est inséré entre les flancs latéraux du substrat et le cadre 50, par exemple sous forme de granulés, de bande extrudée, ou de cadre préfabriqué. Le couvercle de moule 51 est alors refermé. La face interne de ce couvercle peut être structurée afin d'imprimer une texturation sur la face avant de panneau photovoltaïque 1.

Le moule peut comprendre une entrée d'aspiration non représentée pour vider l'air résiduel dans le moule. Après cette aspiration optionnelle, l'ensemble est placé dans une enceinte de chauffage entre 130 et 200°C afin de faire fondre le matériau d'encapsulation et de fusionner les volumes 40 à 43.

Après refroidissement, le moule 5 est ouvert et le panneau photovoltaïque 1 peut être extrait. Il reste alors à dégager les fils de connexion depuis la face arrière ou la tranche du panneau.

Le procédé de l'invention peut aussi être adapté à la fabrication de panneaux photovoltaïques bifaces. Dans ce cas, il est possible de prévoir de cellules photovoltaïques également sur la face arrière du substrat 2, puis d'encapsuler ensemble les cellules photovoltaïques de la face avant et celles de la face arrière.

## Revendications

1. Procédé de fabrication de panneau photovoltaïque (1), comprenant les étapes suivantes :
placer un premier volume (40) d'un matériau d'encapsulation sur le fond d'un moule (5) ;
placer un substrat (2) en matériau biosourcé par-dessus ledit premier volume (40), l'épaisseur dudit matériau biosourcé étant comprise entre 2mm et 50mm ;
disposer une ou plusieurs cellules photovoltaïques (3) sur la face supérieure du substrat (2) ;
placer un deuxième volume (41) d'un matériau d'encapsulation par-dessus les cellules photovoltaïques (3) et la face supérieure du substrat (2) ;
placer un troisième volume (42) d'un matériau d'encapsulation à l'intérieur du moule (5) tout autour du substrat (2) ;
refermer le moule (5) ;
chauffer lesdits matériaux d'encapsulation de manière à fusionner les trois volumes (40, 41, 42) de manière à former une enveloppe hermétique autour du substrat (2) et des cellules (3) ;
refroidir les lesdits matériaux d'encapsulation ;
extraire du moule (5) le panneau photovoltaïque encapsulé sur toutes ses faces.

2. Procédé selon la revendication 1, dans lequel lesdits premier, deuxième et troisième volumes (40, 41, 42) comprennent un même matériau d'encapsulation, de manière à obtenir un panneau photovoltaïque encapsulé sur toutes ses faces de manière monolithique.

3. Procédé selon l'une des revendications 1 ou 2, dans lequel lesdites cellules photovoltaïques (3) sont collées sur le substrat (3).

4. Procédé selon l'une des revendications 1 ou 2, dans lequel un quatrième volume (43) d'un matériau d'encapsulation est disposé entre le substrat et les cellules photovoltaïques avant l'étape de disposer lesdites cellules, de manière à ce que le quatrième volume (43) soit fusionné avec le deuxième (41) et/ou avec le troisième volume (42) pendant ladite étape de chauffage.

5. Procédé selon la revendication 4, dans lequel le quatrième volume (43) et au moins l'un desdits deuxième et troisième volumes (41, 42), comprennent un même matériau d'encapsulation.

6. Procédé selon l'une des revendications 1 à 5, dans lequel le premier volume (40) et le deuxième volume (41) du matériau d'encapsulation sont apportés sous forme de feuilles, et dans lequel le troisième volume (42) d'encapsulation est apporté sous forme de granulé, de cadre préfabriqué, ou d'une bande extrudée.

7. Procédé selon la revendication 4, le quatrième volume (43) étant apporté sous forme de feuille.

8. Procédé selon l'une des revendications 1 à 7, dans lequel l'interstice entre les parois latérales du substrat (2) et le moule (5) est comprise entre 2mm et 20mm, en sorte que le troisième volume (42) forme un cadre rigide tout autour du substrat une fois refroidi.

9. Procédé selon l'une des revendications 1 à 8, dans lequel le substrat biosourcé (2) est à base de fibres de cellulose, par exemple de papier ou de carton.

10. Procédé selon la revendication 9, dans lequel le substrat biosourcé (2) comporte un carton structuré, par exemple alvéolaire.

11. Procédé selon l'une des revendications 1 à 10, dans lequel au moins l'un desdits matériaux d'encapsulation, de préférence chacun desdits matériaux d'encapsulation, comprennent des polymères, de préférence des thermoplastiques, ou des thermosets.

12. Procédé selon la revendication 11, dans lequel au moins l'un desdits matériaux d'encapsulation, de préférence chacun desdits matériaux d'encapsulation, comprennent des polymères, de préférence des thermoplastiques, par exemple une polyoléfine, ou des thermosets.

13. Procédé selon l'une des revendications 1 à 12, comportant une étape de texturation de la face avant du matériau d'encapsulation (41) lors de son moulage.

14. Panneau photovoltaïque (1) comportant :
un substrat (2) en matériau biosourcé avec une épaisseur comprise entre 2mm et 50mm ;
une ou plusieurs cellules photovoltaïques (3) sur la face supérieure du substrat (2) ;
et une encapsulation (40, 41, 42) enveloppant ledit substrat et lesdites cellules photovoltaïques sur toutes les faces.

15. Panneau photovoltaïque selon la revendication 14, l'épaisseur de ladite encapsulation contre la face supérieure et contre la face inférieure du panneau étant inférieure à 1mm, et l'épaisseur de ladite encapsulation tout autour dudit substrat étant comprise entre 2 et 20mm de manière à former un cadre rigide.

16. Panneau photovoltaïque selon l'une des revendications 14 à 15, dans lequel le substrat (2) biosourcé est à base de fibres de cellulose, par exemple de papier ou de carton.

17. Panneau photovoltaïque selon la revendication 16, dans lequel ledit substrat biosourcé comporte un carton structuré, par exemple alvéolaire.

18. Panneau photovoltaïque selon l'une des revendications 14 à 17, dans lequel l'encapsulation (40, 41, 42) comprend une polyoléfine.

19. Panneau photovoltaïque selon l'une des revendications 14 à 18, la face avant de l'encapsulation (41) étant texturée.

20. Panneau photovoltaïque selon l'une des revendications 14 à 19, comportant une couche supplémentaire d'encapsulation (43) entre ledit substrat (2) et lesdites cellules photovoltaïques (3).

21. Utilisation d'un panneau photovoltaïque selon l'une des revendications 14 à 20 sur une structure fixe d'une construction telle qu'un bâtiment ou couvert à voiture.

22. Utilisation d'un panneau photovoltaïque selon l'une des revendications 14 à 20, accroché en position verticale sur une infrastructure construite telle que une paroi antibruit, une barrière, une glissière, ou une palissade.
